(19) Europäisches Patentamt

European Patent Office

Office européen des brevets

(11) **EP 0 978 945 A1**

(12) **EUROPÄISCHE PATENTANMELDUNG**

(43) Veröffentlichungstag:
**09.02.2000 Patentblatt 2000/06**

(51) Int. Cl.⁷: **H03L 5/00**, H03B 1/04,
**H03B 5/36**

(21) Anmeldenummer: **99114799.2**

(22) Anmeldetag: **28.07.1999**

(84) Benannte Vertragsstaaten:
**AT BE CH CY DE DK ES FI FR GB GR IE IT LI LU
MC NL PT SE**
Benannte Erstreckungsstaaten:
**AL LT LV MK RO SI**

(30) Priorität: **04.08.1998 DE 19835198**

(71) Anmelder:
**Zentrum Mikroelektronik Dresden GmbH
D-01109 Dresden (DE)**

(72) Erfinder:
• **Sorst, Manfred
  01445 Radebeul (DE)**
• **Gieseler, Michael, Dr.
  01189 Dresden (DE)**

(74) Vertreter:
**Patentanwälte
Lippert, Stachow, Schmidt & Partner
Postfach 19 24 38
01282 Dresden (DE)**

(54) **Verfahren zur Erzeugung einer Wechselspannung mit einer quartzstabilisierten Frequenz und Pierce-Oszillatorverstärker zur Durchführung des Verfahrens**

(57)   Der Erfindung, die ein Verfahren zur Erzeugung einer Wechselspannung mit einer quartzstabilisierten Frequenz, bei dem eine Eingangsspannung einer invertierenden rückgekoppelten Verstärkung unterzogen und dabei in eine Schwingung versetzt wird, deren Frequenz stabilisiert wird und einen Pierce-Oszillatorverstärker zur Durchführung des Verfahrens betrifft liegt die Aufgabe zugrunde, unter Beibehaltung eines geringen schaltungstechnischen Aufwandes die abgestrahlte Störenergie sowohl der Spannung als auch des Betriebsstroms zu verringern und die statische Stromaufnahme zu reduzieren.

Dies wird dadurch gelöst, daß die Eingangsspannung einer Transkonduktanzverstärkung unterzogen wird. Anschließend wird die Ausgangsspannung gleichgerichtet und diese gleichgerichtete Ausgangsspannung in einen Rückführungsstrom gewandelt. Dieser Rückführungsstrom wird zusammen mit einem Referenzstromeingang summiert und das Ergebnis dieser Summation der Transkonduktanzverstärkung als Vorstrom ($I_{SUM}$) aufgeprägt. Durch eine Reduktion dieses Vorstromes kann erreicht werden, daß die Ausgangsspannung nur noch eine solche Größe einnimmt, daß die genannten Nachteile des Standes der Technik vermieden werden. Diese Einstellung kann über den Referenzstromeingang erfolgen.

Fig. 1

**Beschreibung**

Die Erfindung betrifft ein Verfahren zur Erzeugung einer Wechselspannung mit einer quartzstabilisierten Frequenz, bei dem eine Eingangspannung einer invertierenden rückgekoppelten Verstärkung unterzogen und dabei in eine Schwingung versetzt wird, deren Frequenz stabilisiert wird.

Die Erfindung betrifft auch einen Pierce-Oszillatorverstärker zur Durchführung des Verfahrens. Dieser ist mit einer ersten und einer zweiten Versorgungsspannung und einem invertierenden Verstärker versehen, der versorgungsspannungsseitig mit den beiden Versorgungsspannungen, ausgangsseitig mit einer Seite eines Quartzes und eingangsseitig mit einer anderen Seite des Quartzes verbunden ist. Dabei ist an der einen Seite des Quartzes ein erster Kondensator und an der zweiten Seite des Quartzes ein anderer Kondensator gegen die zweite Versorgungsspannung geschaltet.

Es ist bekannt, Verstärker-Elemente für integrierte Quartz-Oszillatorschaltungen nach dem PIERCE-Prinzip in CMOS-Schaltungstechnik mittels Invertern zu realisieren. Die Dimensionierung dieser Verstärker ist derart ausgeführt, daß sich bei gleichspannungsmäßiger Verkopplung des Eingangs mit dem Ausgang der gewünschte Arbeitspunkt einstellt und daß die Übertragungsfunktion bei der Nennfrequenz des Quartzes ein Schwingen erlaubt.

Die eigentlich als analoge Verstärker betriebenen Inverter arbeiten in nahezu digitaler Art und Weise, da sie im gesamten Aussteuerbereich ausgelenkt werden. Mithin ist folglich die Stromanstiegsgeschwindigkeit $\frac{dI}{dt}$ relativ groß. Infolge dieser hohen Stromanstiegsgeschwindigkeit entsteht z. B. über die Bonddrähte des Bauelementes eine hohe Störabstrahlung.

Weiterhin bewegt sich der Aussteuerbereich im Bereich zwischen 0 V und einer Betriebsspannung, was eine hohe Flankensteilheit mit sich bringt. Damit laufen die Inverter sehr schnell an die Ansteuergrenze, was beim Ausgangsspannungsverhalten Oberwellen durch nicht lineare Verzerrung zeigt.

Schließlich muß die ungeregelte Inverterverstärkerstufe bezüglich der gewollten Schwingfrequenz entsprechend stark genug dimensioniert werden. Infolge dessen ist der Querstrom im Arbeitspunkt zwischen der ersten Versorgungsspannung und Masse groß, wodurch der Stromverbrauch in erheblichem Maße ansteigt. Er beträgt dann nicht selten einige Milliampere.

Es ist somit Aufgabe der Erfindung, unter Beibehaltung eines geringen schaltungstechnischen Aufwandes die abgestrahlte Störenergie sowohl der Spannung als auch des Betriebsstroms zu verringern und die statische Stromaufnahme zu reduzieren.

Verfahrensseitig wird die Aufgabe dadurch gelöst, daß die Eingangsspannung einer Transkonduktanzverstärkung, deren Vorstrom mittels eines Vorstromes eingestellt wird, unterzogen wird. Anschließend wird die daraus entstehende Spannung gleichgerichtet. Diese gleichgerichtete Ausgangsspannung wird in einen von der Amplitude der Ausgangsspannung reziprok proportionalen oder einen Rückführungsstrom gewandelt. Dieser Rückführungsstrom wird im Falle einer reziproken Proportionalität zusammen mit einem Referenzstrom summiert oder im Falle einer Proportionalität von dem Referenzstrom subtrahiert und das Ergebnis dieser Summation oder Substraktion der Transkonduktanzverstärkung als Vorstrom aufgeprägt. Durch eine gezielte Reduktion dieses Vorstromes kann erreicht werden, daß die Amplitude der Ausgangsspannung nur noch eine solche Größe einnimmt, daß die genannten Nachteile des Standes der Technik vermieden werden.

In einer zweckmäßigen Ausführungsform des Verfahrens wird die Ausgangsspannung einer Zweiweggleichrichtung unterzogen.

In einer weiteren Ausführungsform der Erfindung wird die gleichgerichtete Ausgangsspannung gesiebt. Durch beide Ausführungsformen ist es möglich, ein entsprechend genaues Abbild der Größe der Ausgangsspannung zu erreichen, um somit die Einstellung des Vorstromes entsprechend genau vornehmen zu können.

In einer besonders günstigen Ausführungsform der Erfindung ist vorgesehen, daß vor der Summation der Referenzstrom einer ersten Bewertung und der Rückführungsstrom einer zweiten Bewertung unterzogen wird.

Die Schwingungsbedingung für einen Pierce-Oszillator lautet

$$f_{3dB} < f_{osz} < f_{trans} \bullet \text{ Obwohl die Differenz } \Delta\,(f_{3dB} - f_{trans})$$

konstant ist, liegt diese Differenz bei größerem Referenzstrom im größeren Wertebereich und bei kleineren Referenzstrom im kleineren Wertebereich. Zur Einhaltung der genannten Schwingungsbestimmung sollte $f_{OSZ}$, die durch den Quartz und dessen Beschaltung bestimmt wird, in der Mitte liegen. Aus diesem Grunde ist es zweckmäßig, den Rückstrom und den Referenzstrom mit Faktoren zu bewerten, um die Schwingungsbedingung stets erfüllen zu können.

Anordnungsseitig wird die Aufgabe dadurch gelöst, daß der invertierende Verstärker als Transkonduktanzverstärker ausgeführt ist, der einen Vorstromeingang aufweist. In der erfindungsgemäßen Schaltungsanordnung ist eine Gleichrichterschaltung angeordnet, mit der der Ausgang des Transkonduktanzverstärkers zusätzlich verbunden ist.

Die Schaltungsanordnung kann dadurch fortgebildet werden, daß zwischen der Gleichrichterschaltung und dem Transkonduktor ein Tiefpaßfilter angeordnet wird. Dieser Tiefpaßfilter bewirkt ein Glätten der gleichgerichteten Ausgangsschaltung und somit eine genauere Abbildung des Betrages der Ausgangsspannung.

Weiterhin ist ein Transkonduktor mit einem Spannungseingang und einem Stromausgang vorgesehen. Dessen Spannungseingang ist mit dem gleichgerichteten Ausgang des Tiefpaßfilters verbunden. Schließlich ist eine Summationsschaltung mit zwei Summiereingängen und einem Summationsausgang angeordnet, deren einer Summiereingang mit dem Stromausgang des Transkonduktors deren anderer Summiereingang mit einem Referenzstromeingang des Pierce-Oszillatorverstärkers und dessen Summationsausgang mit dem Vorstromeingang des Transkonduktanzverstärkers verbunden ist.

Durch diese Schaltungsanordnung kann der Vorstrom des Transkonduktanzverstärker solange reduziert werden, bis die Auslenkung am Ausgang dieses Verstärkers nur noch eine Höhe hat, die um eine p bzw. n-Kanalschwellspannung bei CMOS-Schaltungstechnik bzw. je eine Diodenflußspannung bei Bipolar-Anwendungen von der ersten und der zweiten Versorgungsspannung entfernt sind. Damit arbeitet dieser Verstärker im normalen analogen Aussteuerbereich. Es entstehen somit weniger Verzerrungen, was das Störspektrum erheblich reduziert. Gleichzeitig werden die hohen Stromachsanstiegsgeschwindigkeiten, welche bei einem dem Rechtecksignal ähnlicherem Signal entstehen und die damit verbundenen Nachteile vermieden.

In einer besonders günstigen Ausgestaltung der Erfindung ist vorgesehen, daß die Gleichrichterschaltung als Zweiweggleichrichterschaltung ausgebildet ist. Diese kann weiterhin dadurch ausgebildet sein, daß sie aus einem n-Kanal MOSFET und einem p-Kanal MOSFET besteht, die zwischen der ersten Versorgungsspannung und der zweiten Versorgungsspannung in Reihe geschalten sind. Der gemeinsame Verbindungspunkt beider Transistoren wird zusammen mit den Gates dieser Transistoren mit dem Ausgang des Transkonduktanzverstärkers verbunden. Zur Arbeitspunkteinstellung der MOSFET's ist zwischen jedem MOSFET und der jeweiligen Versorgungsspannung je eine Konstanzstromquelle geschaltet.

Eine einfache Möglichkeit der Realisierung des Tiefpaßfilters besteht darin, daß dieses aus einem auf die zweite Versorgungsspannung bezogenen Widerstands-Kondensator-Siebglied besteht, das zwischen dem Ausgang der Gleichrichterschaltung und dem Eingang des Transduktors geschaltet ist.

In einer weiteren Ausgestaltung des erfindungsgemäßen Pierce-Oszillator-Verstärkers ist vorgesehen, daß der Transkonduktor aus vier MOSFET's besteht, die paarweise in Reihe zwischen der ersten Versorgungsspannung und einer Konstanzstromquelle, die ihrerseits mit der zweiten Versorgungsspannung verbunden ist, angeordnet sind. Dabei ist ein Gate eines MOSFET's je eines Paares als Rückkopplungseingang für die gleichgerichtete Ausgangsspannung ausgebildet. Die beiden anderen MOSFET's dienen als Lastelemente, indem ihre Gates mit den Drains verbunden sind, wobei eine Drain-Gateverbindung weiterhin als Quellenseite eines Stromspiegels fungiert.

Durch diesen Transkonduktor wird die rückgekoppelte gleichgerichtete Ausgangsspannung in einen Rückkopplungsstrom gewandelt, der sodann mit dem Referenzstrom summiert den Vorstrom für den Transkonduktanzverstärker liefert.

Die Summationsschaltung ist zweckmäßigerweise dadurch ausgebildet, daß sie jeweils aus drei MOSFET's besteht, wobei das Gate eines ersten Transistors als Spannungseingang für den äquivalenten Rückkopplungsstrom ausgebildet ist. Die beiden anderen Transistoren sind als Stromspiegel geschaltet, wobei der Eingang des Stromspiegels als Eingang des Referenzstromes ausgebildet ist. Der erste Transistor und der Ausgang des Stromspiegels sind gemeinsam auf den Vorstromeingang des Transkonduktanzverstärkers geschaltet.

Damit wird es möglich, daß der Referenzstrom über den Stromspiegel auf den Rückkopplungsstrom gespiegelt wird und somit ein Summationsstrom besteht.

Die Erfindung soll nachfolgend anhand eines Ausführungsbeispieles näher erläutert werden. In den zugehörigen Zeichnungen zeigt

Fig. 1     eine Gesamtschaltungsanordnung in einer Übersichtsdarstellung und

Fig. 2     eine Darstellung der Summierschaltung.

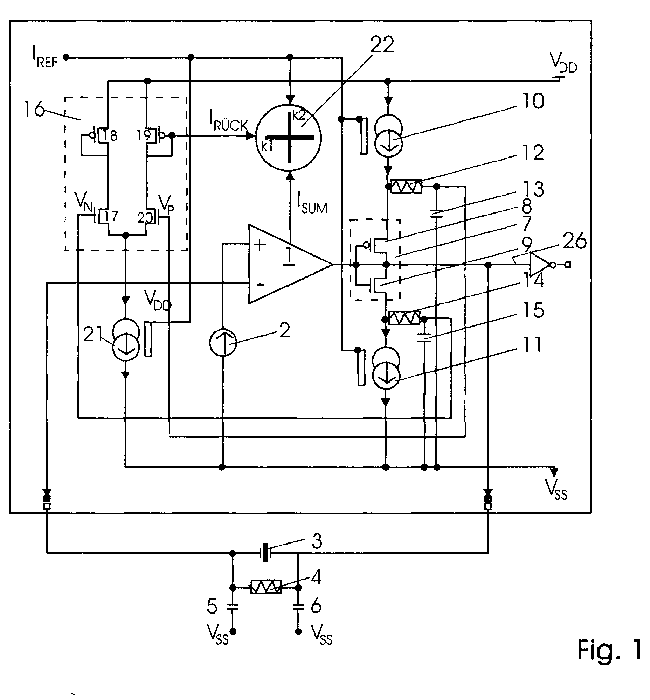

Wie in Fig. 1 dargestellt, ist wesentlicher Inhalt der erfindungsgemäßen Schaltungsanordnung ein Transkonduktanzverstärker 1. Zum Betrieb der Schaltungsanordnung wird eine erste Versorgungsspannung $V_{DD}$ und eine zweite Versorgungsspannung $V_{SS}$ bereitgestellt. Der Arbeitspunkt des Transkonduktanzverstärkers 1 wird über eine Spannungsquelle 2, die zwischen dem nicht invertierten Eingang des Transkonduktanzverstärkers 1 und der Versorgungsspannung $V_{SS}$ geschaltet ist, auf $V_{DD}/2$ eingestellt.

Der Ausgang des Transkonduktanzverstärkers 1 ist auf einen Anschluß eines Quartzes 3 geführt. Der andere Anschluß des Quartzes 3 ist mit dem invertierenden Eingang des Transkonduktanzverstärkers 1 verbunden. Der Quartz selbst ist mit einem parallel geschalteten Widerstand 4 und beidseitig mit je einem Kondensator 5 und 6, die gegen die Versorgungsspannung $V_{SS}$ geschalten sind, versehen.

Der Widerstand 4 kann selbstverständlich in einer anderen Ausführungsform auch Bestandteil des Schaltkreises sein und bei MOS-Schaltungstechnik in Form eines sehr hochohmigen Transfergates ausgeführt sein.

Weiterhin ist der Ausgang des Transkonduktanzverstärkers 1 mit einer Zweiweggleichrichterschaltung 7 versehen. Diese besteht aus einem Transistor 8 eines ersten Leitfähigkeitstyps und einem Transistor 9 eines anderen zweiten Leifähigkeitstyps, deren Gates und deren gemeinsamer Anschlußpunkt mit dem Ausgang des Transkonduktanzverstärkers 1 verbunden sind, und zwei Konstantstromquellen 10 und 11 zur Arbeitspunkteinstellung, die zwischen der ersten Versorgungsspannung $V_{DD}$ und dem Sourceanschluß des MOS-Transistors 8 vom ersten Leitfähigkeitstyp bzw. zwischen der Versorgungsspannung $V_{SS}$ und dem Sourcesanschluß des zweiten zur Gleichrichterschaltung gehörigen MOS-Transistors 9 vom zweiten Leitfähigkeitstyp geschaltet sind. Am ersten Ausgang der Gleichrichterschaltung 7, gebildet vom Stromquellenausgang der Stromquelle 10 und dem Sourcegebiet des MOS-Transistors 8, ist eine Siebschaltung, bestehend aus Widerstand 12 im Längszweig der Siebschaltung und Kondensator 13 gegen die zweite Versorgungsspannung $V_{SS}$ am Ausgang der Siebschaltung angeschlossen. In gleicher Weise ist am zweiten Ausgang der Gleichrichterschaltung 7, der vom Stromquellenausgang der Stromquelle 11 und dem Sourcegebiet des MOS-Transistors 9 gebildet wird, eine weitere Siebschaltung, bestehend aus Widerstand 14 im Längszweig dieser zweiten Siebschaltung und Kondensator 15 gegen die zweite Versorgungsspannung $V_{SS}$ am Ausgang dieser zweiten Siebschaltung angeschlossen;

Beide Siebschaltungen, bestehend aus dem Widerstand 12 und dem Kondensator 13 bzw. aus dem Widerstand 14 und dem Kondensator 15 dienen als Tiefpaßfilter für die zu erzeugende gleichgerichtete Ausgangsspannung je einer Halbwelle der Ausgangsspannung des Transkonduktionsverstärkers 1.

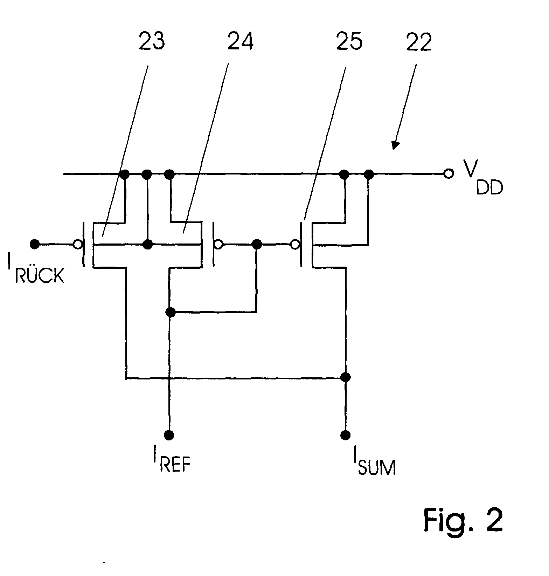

In der Schaltung ist weiterhin ein Transkonduktor 16 angeordnet, der aus den Transistoren 17, 18, 19 und 20 besteht. Dabei sind die Transistoren 17 und 18 in Reihe und ebenfalls die Transistoren 19 und 20 in Reihe geschalten und beide Reihenschaltungen parallel geschalten. Beide Reihenschaltungen sind über eine Konstantstromquelle 21 mit der zweiten Versorgungsspannung $V_{SS}$ verbunden. Innerhalb des Transkonduktors sind die Gates der Transistoren 18 und 19 jeweils mit ihren Drains verbunden. Die Gates der Transistoren 17 und 20 stellen die Eingänge des Transkonduktors 16 dar. Auf der zur Konstantstromquelle 21 anderen Seite der Reihenparallelschaltung ist der Transkonduktor 16 mit der ersten Versorgungsspannung $V_{DD}$ verbunden. Nunmehr sind der Ausgang des ersten Siebgliedes , d.h. der Verbindungspunkt der Schaltelemente 13 und 13, mit dem ersten Eingang des Transkonduktors 16, d.h. dem Gate des Transistors 20 und der Ausgang des zweiten Siebgliedes, d.h. der Verbindungspunkt der Schaltelemente 14 und 15, mit dem zweiten Eingang des Transkonduktors 16. d.h. dem Gate des Transistors 16 verbunden. Die Gate-Drain-Verbindung des Transistors 19 stellt gleichzeitig den Ausgang des Transduktors 16 sowie die Sendeseite für den mit der Summierschaltung, wie sie in Fig. 2 dargestellt ist, dar. Der Ausgang des Transkonduktors 16 ist somit auf den Rückstrom-Spannungseingang $I_{Rück}$ der Summationsschaltung 22 geschaltet. Ein zweiter Eingang dieser Summationsschaltung 22 ist mit einer externen Referenzstromquelle $I_{REF}$ verbunden.

Am Ausgang der Summationsschaltung 22 liegt der Summenstrom $I_{SUM}$ als Vorstrom an dem Vorstromeingang an dem Transkonduktanzverstärker 1.

Wie in Fig. 2 dargestellt, besteht die Summationsschaltung aus einem Transistor 23, der entsprechend dem mit Transistor 23 und dem Transistor 19 aus Fig. 1 eingestellten Spiegelverhältnis die aus dem Transkonduktor 16 gewonnene Rückstrominformation (entsprechend der Ausgangsansteuerung des Transkonduktonsverstärkers 1) bereitstellt, sowie aus dem durch die Transistoren 24 und 25 gebildeten Stromspiegel, wobei über das Spiegelverhältnis von Transistor 24 zu Transistor 25 der Grundwert des Summenstromes bezüglich des Eingangsreferenzstromes $I_{REF}$ eingestellt wird, wodurch sich am Summenknoten $I_{SUM}$ bei angeschlossener Last, die durch den Vorstromeingang des Transkonduktanzverstärkers 1 gebildet wird, der von der Ausgangsamplitude indirekt proportional abhängige Vorstrom für den Transkonduktanzverstärker ergibt, d.h. bei Erreichen einer genügend hohen Ausgangsamplitude wird der Strombedarf der Schaltung reduziert.

Der Transkonduktanzverstärker 1 bringt sowohl die erforderliche Leerlauf-Verstärkung, als auch mit der angeschlossenen Lastkapazität 6 eine Phasendrehung im Bereich vom 270 bis 360 Grad auf, damit die Schwingbedingung bei der Parallelresonanzfrequenz des Quartzes erfüllt wird. Der invertierende Eingang des Transkonduktanzverstärkers 1 und dessen Ausgang ist sowohl mit dem extern angeschlossenen Quartz 3 und mit dem für die Arbeitspunkt-Einstellung erforderlichen Widerstand 4 verbunden. Die Kondensatoren 5 und 6 dienen im Zusammenhang mit den chipeigenen PIN-Kapazitäten am Ausgangspin des Transkonduktanzverstärkers 1 und am PIN für den negierenden Eingang des Transkonduktanzverstärkers 1 der Herstellung der Einmeßbedingung für den Quartz 3. Die Kapazität 6 bestimmt gemeinsam mit den (chipinternen) Eigenschaften des Transkonduktanzverstärkers 1 sowohl die 3dB- als auch die Transitfrequenz im Übertragungsverhalten der Verstärkungsanordnung, d.h. die frequenzmäßige Lage des -20dB/Dekade-Abfalles der Verstärkung.

Der Arbeitspunkt wird schaltungsintern durch eine Gleichspannung am nichtinvertierenden Eingang des Transkonduktanzverstärkers 1 eingestellt. Der Arbeitspunkt sollte in der Mitte des Aussteuerbereiches, also, beispielsweise, wie bereits erwähnt, auf $V_{DD}/2$ eingestellt sein. Für das Gleichspannungsverhalten stellt die vorliegende Schaltung bezüglich der Spannung am nichtinvertierenden Eingang des Transkonduktanzverstärkers 1 einen Spannungsfolger dar. Dies ist deshalb wichtig, da bei der Realisierung auf einem "Sea of Gates" auf Grund der minimalen Kanallänge eine große Eingangs-Oftsetspannung für den Transkonduktanzverstärker 1 zu erwarten ist.

Der Transkonduktanzverstärker 1 selbst ist in bekannter statischer CMOS-Schaltungstechnik aufgebaut. Die internen Arbeitspunkte werden mittels eines Vorstromes $I_{SUM}$ eingestellt. Dieser Vorstrom $I_{SUM}$ wird über eine Summationsschaltung 22 sowohl von dem von außen zuzuführenden Referenzstrom $I_{Ref}$, als auch von dem Transkonduktor 16 abgeleiteten Rückführstrom $I_{Rück}$ gebildet. Der Transkonduktor 16 führt dabei eine Stromumverteilung eines ebenfalls aus $I_{ref}$ abgeleiteten Stromes aus, welche von den Eingangsspannungen VP und VN gesteuert wird.

Die Eingangsströme der Summationsschaltung 22 werden über die Stromspiegelverhältnisse mit unterschiedlichen Faktoren KI für den Rückführstrom $I_{Ref}$ aus dem Transkonduktor 16 und K2 für den extern eingespeisten Referenzstrom $I_{ref}$ bewertet. Die Bereitstellung der Steuerspannungen VP und VN für den Transkonduktor 16 erfolgt durch die an der Einschnürgrenze gehaltenen n- und p-Kanal-Transistoren 8 und 9, welche bevorzugt positivere (bei dem Transistor 8) bzw. bevorzugt negativere Spannungen (bei dem Transistor 9) übertragen können, die die Funktion der Gleichrichterschaltung 7 realisiert, sowie der nachgeschalteten Siebschaltung 12, 13, 14, 15. Die Einstellung von deren Arbeitspunkten erfolgt mittels sehr niedriger Ströme über die Konstantstromquellen 10 und 11 mit sehr kleinen Source-Drain-Strömen. Die Zeitkonstanten die R/C-Glieder sind so dimensioniert, daß die zu erzeugende Frequenz genügend unterdrückt wird. Die beschriebene Gleichrichterschaltung 7 mit den Tiefpaßfiltern 12; 13 und 14; 15 besitzt eine gleichrichtende Wirkung, ohne daß Dioden zwingend erforderlich sind.

Die gesamte Schaltungsstruktur sichert, daß das Signal am Oszillator-Verstärkerausgang 26 nur bis ungefähr eine Schwellspannung des n-Kanal-Transistors 8 unterhalb der ersten Versorgungsspannung $V_{DD}$ und bis etwa eine Schwellspannung des n-Kanal-Transistors 9 über der zweiten Versorgungsspannung und damit nahezu symmetrisch und oberwellenarm um den eingestellten Arbeitspunkt $V_{DD}$/2 ausgelenkt wird. Je kleiner die Ströme über die Konstantstromquellen 10 und 11 sind, desto genauer wird die entsprechende Schwellspannung abgebildet.

**<u>Bezugszeichenliste</u>**

| | |
|---|---|
| 1 | Transkonduktanzverstärker |
| 2 | Spannungsquelle |
| 3 | Quartz |
| 4 | Widerstand |
| 5 | Kondensator |
| 6 | Kondensator |
| 7 | Zweiweggleichrichterschaltung |
| 8 | Transistor |
| 9 | Transistor |
| 10 | Konstantstromquelle |
| 11 | Konstantstromquelle |
| 12 | Widerständ |
| 13 | Kondensator |
| 15 | Kondensator |
| 14 | Widerstand |
| 16 | Transkonduktor |
| 17 | Transistor |
| 18 | Transistor |
| 19 | Transistor |
| 20 | Transistor |
| 21 | Konstantstromquelle |
| 22 | Summationsschaltung |
| 23 | Transistor |
| 24 | Transistor |
| 25 | Transistor |
| 26 | Verstärkerausgang |
| $I_{ref}$ | Referenzstromeingang |
| $I_{rück}$ | Rückkkopplungspannungseingang zur Einstellung des Rückstomes |
| $I_{sum}$ | Vorstrom |
| K1 | Bewertungsfaktor |
| K2 | Bewertungssfaktor |
| $V_{DD}$ | erste Versorgungsspannung |

$V_{SS}$    zweite Versorgungsspannung
$V_P$    Eingangsspannung
$V_N$    Eingangsspannung

## Patentansprüche

1. Verfahren zur Erzeugung einer Wechselspannung mit einer quartzstabilisierten Frequenz, bei dem eine Eingangsspannung einer invertierenden rückgekoppelten Verstärkung unterzogen und dabei in eine Schwingung versetzt wird, wobei die Frequenz stabilisiert wird, **dadurch gekennzeichnet,** daß die Eingangsspannung einer Transkonduktanzverstärkung, dessen Frequenzgangverhalten mittels eines Vorstromes eingestellt wird, unterzogen wird, anschließend gleichgerichtet wird, die gleichgerichtete Ausgangsspannung in einen von der Ausgangsspannung reziprok proportionale oder proportionale Rückführungsstrom gewandelt wird, dieser Rückführungsstrom $I_{rück}$ mit einem Referenzstromeingang ($I_{ref}$)im Falle reziproker Proportionalität summiert und im Falle einer Proportionalität von von dem Referenzstromeingang ($I_{ref}$) substrahiert wird und das Ergebnis dieser Summation oder Substraktion der Transkonduktanzverstärkung als Vorstrom ($I_{sum}$) aufgeprägt wird.

2. Verfahren nach Anspruch 1, **dadurch gekennzeichnet,** daß die Ausgangsspannung einer Zweiweggleichrichtung unterzogen wird.

3. Verfahren nach Anspruch 1 oder 2, **dadurch gekennzeichnet,** daß die gleichgerichtete Ausgangsspannung gesiebt wird.

4. Verfahren nach einem der Ansprüche 1 bis 3, **dadurch gekennzeichnet,** daß vor der Summation der Referenzstrom ($I_{ref}$) einer ersten Bewertung (K1) und der Rückführungstrom ($I_{rück}$) einer zweiten Bewertung (K2) unterzogen wird.

5. Pierce-Oszillatorverstärker zur Durchführung des Verfahrens nach Anspruch 1, mit einer ersten und einer zweiten Versorgungsspannung und mit einem invertierenden Verstärker, der versorgungsspannungsseitig mit den beiden Versorgungsspannungen, ausgangsseitig mit einer Seite eines Quartzes und eingangsseitig mit einer anderen Seite des Quartzes verbunden ist, wobei an der einen Seite des Quartzes ein erster Kondensator und an der zweiten Seite des Quartzes ein anderer Kondensator gegen die zweite Versorgungsspannung geschalten ist, **dadurch gekennzeichnet,** daß der invertierende Verstärker als Transkonduktanzverstärker (1) ausgeführt ist, der einen Vorstromeingang ($I_{sum}$) aufweist,

   daß eine Gleichrichterschaltung (7) angeordnet ist, mit der der Ausgang des Transkonduktanzverstärkers (1) zusätzlich verbunden ist,

   daß zwischen die Gleichrichterschaltung (7) und dem Transkonduktor (16) ein Tiefpaßfilter (12; 13 und 14; 15) angeordnet ist,

   daß ein Transkonduktor (16) mit einem Spannungseingang und einem Stromausgang vorgesehen ist, dessen Spannungseingang mit dem gleichgerichteten Ausgang des Tiefpaßfilters (12; 13; 14; 15) verbunden ist, und

   daß eine Summationsschaltung (22) mit zwei Summiereingängen und einem Summationsausgang angeordnet ist, deren einer Summiereingang mit dem Stromausgang des Transkonduktors (16), deren anderer Summiereingang mit einem Referenzstromeingang ($I_{Ref}$) des Pierce-Oszillatorverstärkers und dessen Summationsausang mit dem Vorstromeingang ($I_{sum}$) des Transkonduktanzverstärkers (1) verbunden ist.

6. Pierce-Oszillatorverstärker nach Anspruch 5, **dadurch gekennzeichnet,** daß die Gleichrichterschaltung als Zweiweggleichrichterschaltung (7) ausgebildet ist.

7. Pierce-Oszillatorverstärker nach Anspruch 6, **dadurch gekennzeichnet,** daß die Zweiweggleichrichterschaltung (7) aus einem n-Kanal MOSFET (7) und einem p-Kanal-MOSFET (8) besteht, die zwischen der ersten Versorgungsspannung ($V_{DD}$) und der zweiten Versorgungsspannung ($V_{SS}$) in Reihe geschalten sind, der gemeinsamer Verbindungspunkt zusammen mit deren Gates mit dem Ausgang des Transkonduktanzverstärkers (1) verbunden sind, wobei zwischen jedem der MOSFETs (8; 9) und der jeweiligen Versorgungsspannung ($V_{DD}$; $V_{SS}$) je eine Konstantstromquelle (10; 11) geschaltet ist.

8.  Pierce-Oszillatorverstärker nach Anspruch 7, **dadurch gekennzeichnet,** daß das Tiefpaßfilter aus einem auf die zweite Versorgungsspannung ($V_{SS}$) bezogenen Widerstands-Kondensator-Siebglied (12; 13 und 14; 15) besteht, das zwischen dem Ausgang der Gleichrichterschaltung und dem Eingang des Transkonduktors (16) geschaltet ist.

9.  Pierce-Oszillatorverstärker nach einem der Ansprüche 5 bis 8, **dadurch gekennzeichnet,** daß der Transkonduktor (16) aus vier MOSFETs (17; 18; 19; 29) besteht, die paarweise in Reihe zwischen der ersten Versorgungsspannung ($V_{DD}$) und einer Konstantstromquelle (21), die ihrerseits mit der zweiten Versorgungsspannung ($V_{SS}$) verbunden ist, angeordnet sind, wobei ein Gate eines MOSFETs (17; 20) je eines Paares als Rückkopplungseingang für die gleichgerichtete Ausgangsspannung ($V_N$; $V_P$) ausgebildet ist und die beiden anderen MOSFETs (18; 19) als Lastelemente dienen, indem ihre Gates mit den Drains verbunden sind, wobei eine Drain-Gate-Verbindung die Quellenseite eines Stromspiegels bildet.

10. Pierce-Oszillatorverstärker nach einem der Ansprüche 5 bis 9, **dadurch gekennzeichnet,** daß die Summationsschaltung (22) aus drei FETs (23; 24; 25) besteht, wobei das Gate eines ersten Transistors (23) als Stromeingang für den äquivaltenten Rückkopplungsstrom ($I_{Ruck}$) ausgebildet ist und die beiden anderen (24; 25) als Stromspiegel geschaltet sind, wobei der Eingang des Stromspiegels als Eingang des Referenzstromeinganges ($I_{ref}$) ausgebildet ist, und daß der erste Transistor (23) und der Ausgang des Stromspiegel gemeinsam auf den Vorstromeingang ($I_{Sum}$) des Transkonduktanzverstärkers (1) geschaltet sind.

**Fig. 1**

Fig. 2

**Europäisches Patentamt**

## EUROPÄISCHER RECHERCHENBERICHT

Nummer der Anmeldung

EP 99 11 4799

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | EP 0 384 938 A (SIEMENS AG) 5. September 1990 (1990-09-05) * Spalte 1, Zeile 4 - Zeile 29 * * Spalte 2, Zeile 22 - Spalte 5, Zeile 45; Abbildungen * | 1,3,5 | H03L5/00 H03B1/04 H03B5/36 |
| A | --- | 9 | |
| L | VITTOZ E A ET AL: "HIGH-PERFORMANCE CRYSTAL OSCILLATOR CIRCUITS: THEORY AND APPLICATION" IEEE JOURNAL OF SOLID-STATE CIRCUITS., Bd. 23, Nr. 3, Juni 1988 (1988-06), Seiten 774-783-783, XP000670599 IEEE INC. NEW YORK., US ISSN: 0018-9200 dieses Dokument wird in EP 0 384 938 A erwähnt * Zusammenfassung * * Seite 779, Spalte 1, Absatz D - Seite 780, Spalte 2, Zeile 12; Abbildungen 10,11 * | | |
| | --- | | |
| L | VITTOZ E ET AL: "CMOS ANALOG INTEGRATED CIRCUITS BASED ON WEAK INVERSION OPERATION" IEEE JOURNAL OF SOLID-STATE CIRCUITS., Bd. 12, Nr. 3, Juni 1977 (1977-06), Seite 224-231 XP000568056 IEEE INC. NEW YORK., US ISSN: 0018-9200 dieses Dokument wird im Dokument XP000670599 (Vittoz et al.)erwähnt * Seite 228, Spalte 2, Zeile 14 - Seite 229, Spalte 2, letzte Zeile; Abbildungen 10,12 * | | |
| | --- | | |

RECHERCHIERTE SACHGEBIETE (Int.Cl.7)

H03L
H03B
H03K

-/--

Der vorliegende Recherchenbericht wurde für alle Patentansprüche erstellt

| Recherchenort | Abschlußdatum der Recherche | Prüfer |
|---|---|---|
| DEN HAAG | 15. November 1999 | Balbinot, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

**Europäisches Patentamt**

# EUROPÄISCHER RECHERCHENBERICHT

Nummer der Anmeldung

EP 99 11 4799

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 4 013 979 A (VITTOZ ERIC) 22. März 1977 (1977-03-22) * Spalte 5, Zeile 9 - Spalte 6, Zeile 21; Abbildungen 6,7 * --- | 1,5 | |
| A | US 5 113 156 A (MAHABADI JOHN K ET AL) 12. Mai 1992 (1992-05-12) * Spalte 1, Zeile 56 - Zeile 62 * * Spalte 2, Zeile 38 - Spalte 5, Zeile 38; Abbildung 4 * --- | 1,5 | |
| A | ANDREW M. HUDOR JR: "FET-controlled crystal yields low distortion" EDN ELECTRICAL DESIGN NEWS., Bd. 25, Nr. 21, November 1980 (1980-11), Seite 201 XP002122419 CAHNERS PUBLISHING CO. NEWTON, MASSACHUSETTS. 81963 1, US ISSN: 0012-7515 * das ganze Dokument * ----- | 1,3,5 | |
| | | | RECHERCHIERTE SACHGEBIETE (Int.Cl.7) |

Der vorliegende Recherchenbericht wurde für alle Patentansprüche erstellt

| Recherchenort | Abschlußdatum der Recherche | Prüfer |
|---|---|---|
| DEN HAAG | 15. November 1999 | Balbinot, H |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

**ANHANG ZUM EUROPÄISCHEN RECHERCHENBERICHT**
**ÜBER DIE EUROPÄISCHE PATENTANMELDUNG NR.**    EP 99 11 4799

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-11-1999

| Im Recherchenbericht angeführtes Patentdokument | Datum der Veröffentlichung | Mitglied(er) der Patentfamilie | | Datum der Veröffentlichung |
|---|---|---|---|---|
| EP 0384938 A | 05-09-1990 | DE | 58908698 D | 12-01-1995 |
| | | US | 4999588 A | 12-03-1991 |
| US 4013979 A | 22-03-1977 | CH | 580358 A | 30-09-1976 |
| | | DE | 2541352 A | 08-04-1976 |
| | | JP | 1223590 C | 15-08-1984 |
| | | JP | 51076951 A | 03-07-1976 |
| | | JP | 58052364 B | 22-11-1983 |
| US 5113156 A | 12-05-1992 | KEINE | | |

EPO FORM P0461